# EUROPÄISCHE PATENTSCHRIFT

(11) **EP 0 558 516 B1**
(45) Veröffentlichungstag und Bekanntmachung des Hinweises auf die Patenterteilung: **10.01.1996**
(21) Anmeldenummer: 91919229.4
(22) Anmeldetag: 22.10.1991
(51) Int. Cl.: F02P 17/00, G01R 31/06

(54) **SCHALTUNG ZUR ZÜNDKERZENSIMULATION**
SPARK-PLUG SIMULATOR
CIRCUIT POUR LA SIMULATION D'UNE BOUGIE D'ALLUMAGE

(30) Priorität: 24.11.1990 DE 4037487
(43) Veröffentlichungstag der Anmeldung: 08.09.1993
(73) Patentinhaber: ROBERT BOSCH GMBH, D-70442 Stuttgart (DE)
(72) Erfinder: BRIDA, Peter, D-7000 Stuttgart 40 (DE); PUETTMANN, Lothar, D-7251 Weissach-Flacht (DE); LUECKE, Hans-Ulrich, D-7000 Stuttgart 80 (DE); MAIER, Juergen, D-7121 Gemmrigheim (DE)
(86) Internationale Anmeldenummer: DE9100820
(87) Internationale Veröffentlichungsnummer: WO9209804

(56) Entgegenhaltungen:
- FR-A- 2 603 951
- US-A- 2 249 157
- US-A- 3 521 156

## Beschreibung

### Stand der Technik

Die Erfindung geht aus von einer Schaltungsanordnung zur Simulation des elektrischen Verhaltens einer Zündkerze nach der Gattung des Hauptanspruchs. Es ist bereits aus einem Prüfgerät für Zündspulen bekannt, eine Kerzennachbildung in Form eines R- oder RLC-Gliedes vorzunehmen. Bei dieser Kerzenachbildung kann jedoch nur eine reine Belastung der Zündkerze simuliert werden und der Signalverlauf ist ein völlig anderer als der Signalverlauf der Brennspannung. Das heißt, bei der Prüfung von Zündspulen oder Zündanlagen insbesondere mit einer Zündspannungsüberwachung sind die bekannten Schaltungen der Kerzennachbildung nicht ausreichend.

### Vorteile der Erfindung

Die erfindungsgemäße Schaltung mit den kenzeichnenden Merkmalen des Hauptanspruchs hat gegenüber dem Bekannten den Vorteil, daß die erfindungsgemäße Kerzennachbildung den Signalverlauf der Brennspannung sehr genau simuliert.

Die Zündspannung einer Zündanlage kann damit gegebenenfalls auch primärseitig geprüft werden, was insbesondere für neuere Zündanlagen mit integrierter Zündspannungsüberwachung vorteilhaft ist. Als weiterer Vorteil ist anzusehen, daß die Kerzennachbildung sowohl für positive als auch für negative Zündspannungen, wie sie in Doppelfunkenspulen auftreten, einsetzbar ist.

Durch die in den Unteransprüchen aufgeführten Maßnahmen sind vorteilhafte Weiterbildungen und Verbesserungen der im Hauptanspruch angegebenen Schaltung möglich. Besonders vorteilhaft ist, daß die Durchbruchspannung mit geringer Streuung sehr genau vorwählbar ist, so daß sie der Ansprechspannung der Zündkerze entspricht. Letztendlich sei als Vorteil noch erwähnt, daß das Signal an der Zündkerzennachbildung für die Signalübertragung beispielsweise mittels LED in Licht umgewandelt und per Lichtwellenleiter an eine Auswerteschaltung übertragen werden kann.

### Zeichnung

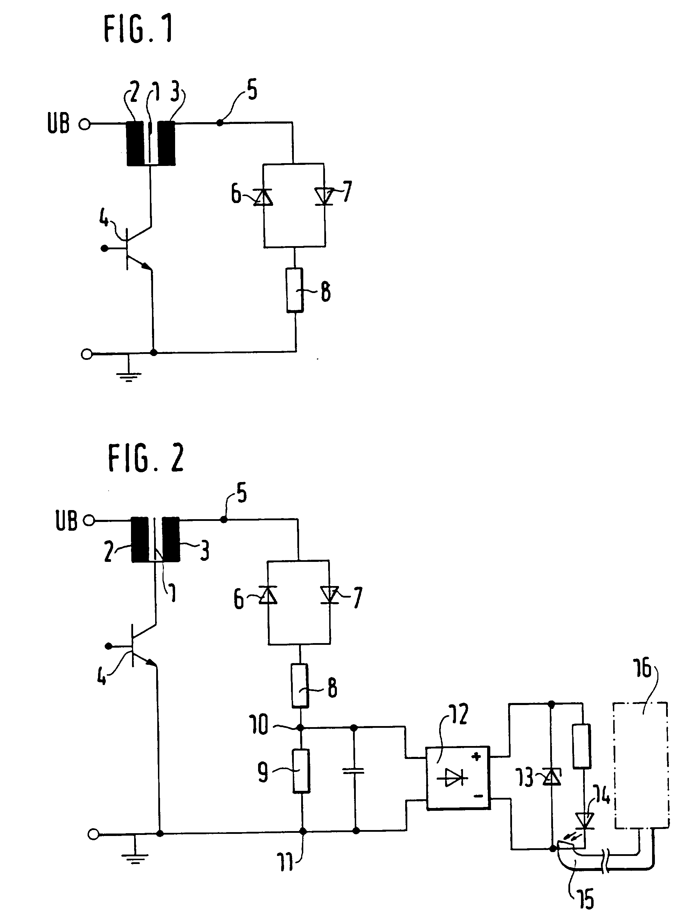

Ausführungsbeispiele der Erfindung sind in der Zeichnung dargestellt und in der nachfolgenden Beschreibung näher erläutert. Es zeigen die Figur 1 eine Prinzipschaltung für die elektronische Zündkerzensimulation, die Figur 2 eine zweite Schaltung für die elektronische Zündkerzensimulation mit Brückengleichrichter zur Signalauswertung.

### Beschreibung der Ausführungsbeispiele

Die Prinzipschaltung in Figur 1 für eine Zündkerzennachbildung enthält eine Zündspule 1 bestehend aus einer Primärwicklung 2 und einer Sekundärwicklung 3. Die Primärwicklung 3 ist einerseits mit einer Batteriespannung UB und andererseits über einen Steuertransistor 4 mit Masse verbunden. Auf der Sekundärseite liegt in Reihe mit der Sekundärwicklung 3 eine Klemme 5, die Parallelschaltung zweier Kippdioden 6 und 7 und ein Widerstand 8, wobei die Dioden 6 und 7 in den parallelen Zweigen mit unterschiedlicher Polarität angeordnet sind. Das heißt, die Diode 6 ist so geschaltet, daß die Kathode an der Sekundärwicklung 3 und die Anode am Widerstand 8 liegt. Bei der Diode 7 liegt im Gegensatz dazu die Anode an der Sekundärwicklung 3 und die Kathode am Widerstand 8.

Die eben beschriebene Schaltung hat folgende Wirkungsweise. In der Primärwicklung 2 der Zündspule 1 wird der Stromfluß durch das Anlegen einer Spannung an die Basis des Steuertransistors 4 eingeschaltet. Beim Ausschalten des Steuertransistors 4 wird der Strom in der Zündspule abgeschaltet und damit in der Sekundärwicklung 3 eine Hochspannung induziert. Das heißt, sperrt der Steuertransistor 4, so steigt die Spannung auf der Sekundärseite an den Dioden so lange an, bis die Kippspannung an Diode 6 beziehungsweise an Diode 7 erreicht ist. Diese Zeit ist die Anstiegsphase. Ist die Durchbruchsspannung erreicht, die sehr genau derart vorwählbar ist, daß sie der Ansprechspannung einer intakten Zündkerze entspricht, so bricht die Kippdiode 6 beziehungsweise 7 schlagartig durch. In dieser Durchbruchsphase wird die Kippdiode leitend. Damit fließt durch den Widerstand 8 ein Strom. Der Spannungsabfall an diesem Widerstand entspricht nun der Brennspannung der Zündkerze. Damit wird die in der Zündspule gespeicherte Energie verbraucht, und es sinkt die Spannung an den Kippdioden. Unterschreitet nun der Strom den Haltestrom der Kippdioden, so schwingt die Spannung auf der Sekundärseite gedämpft aus. Der so entstehende Spannungsverlauf kann nun einer Auswerteschaltung zugeführt werden, und man erhält Informationen über die Funktion der Zündspule. Die Auswerteschaltung ist primär- oder sekundärseitig vorzusehen.

Figur 2 zeigt eine Weiterentwicklung der Prinzipschaltung zur Zündkerzensimulation gemäß Figur 1, wobei gleiche Bauelemente gleiche Bezugszeichen haben. Bei dieser Schaltung ist auf der Sekundärseite in Reihe zum Widerstand 8 ein zweiter Widerstand 9 geschaltet. Die Spannung über diesen Widerstand 9 wird an Klemmen 10 und 11 abgegriffen und über einen Brückengleichrichter 12 gleichgerichtet. Die Spannung nach dem Brückengleichrichter wird an eine Zenerdiode 13 weitergegeben, zu der eine Leuchtdiode 14 mit Vorschaltwiderstand parallelgeschaltet ist.

Diese Schaltung in Figur 2 hat folgende Wirkungsweise. Der Aufbau der Hochspannung auf der Sekundärseite und der Durchbruch der Kippdioden 6 und 7 ist analog der Figur 1. Nach dem Durchbruch der Kippdioden 6 und 7 fällt am Widerstand 8 und 9 eine stromproportionale Spannung ab. Von der insgesamt abfallenden Spannung wird nur die zur Auswertung verwendete Spannung am Widerstand 9 abgegriffen. Da diese Spannung abhängig von der Zündfolge positiv oder negativ sein kann, wird sie über den Brückengleichrichter 12 gleichgerichtet. Die Zenerdiode 13 begrenzt diese Spannung und während der nachgebildeten Brennphase leuchtet die Leuchtdiode 14. Dieser Lichtimpuls der Leuchtdiode 14 kann nun über einen Lichtwellenleiter 15 an eine entsprechende Anzeige oder Auswertevorrichtung 16 weitergegeben werden.

Die Klemme 5, sowohl in Figur 1 als auch in Figur 2 dargestellt, ermöglicht durch eine entsprechende Ausbildung dieser Klemme, daß die originalen Kerzenstecker des "Prüfmotors" direkt auf die elektronische Kerzensimulation gesteckt werden können, wobei für die Simulation der Zündkerze keine Druckkammer benötigt wird.

## Patentansprüche

1. Schaltungsanordnung zur Simulation des elektrischen Verhaltens einer Zündkerze, dadurch gekennzeichnet, daß die Kerzennachbildung eine Reihenschaltung aus mindestens einem Widerstand (8) und zwei antiparallel geschalteten Kippdioden (6, 7) ist.

2. Schaltungsanordnung nach Anspruch 1, dadurch gekennzeichnet, daß die Kippdioden (6, 7) bei einer vorwählbaren, der Ansprechspannung einer Zündspule entsprechenden Durchbruchspannung leitend werden, wobei dann der Spannungsabfall am Widerstand (8) der Brennspannung einer Zündkerze entspricht.

3. Schaltungsanordnung nach einem der vorherigen Ansprüche, dadurch gekennzeichnet, daß die originalen Kerzenstecker einer Zündanlage durch entsprechende Ausbildung einer Klemme (5) direkt auf die Kerzennachbildung aufsteckbar sind.

4. Schaltungsanordnung nach einem der vorherigen Ansprüche, dadurch gekennzeichnet, daß dem Widerstand (9) ein Brückengleichrichter (10) parallel geschaltet ist, der die abfallende stromproportionale Spannung für eine anschließende Auswertung gleichrichtet.

5. Schaltungsanordnung nach Anspruch 4, dadurch gekennzeichnet, daß dem Brückengleichrichter eine Leuchtdiode (14) nachgeschaltet ist die per Lichtwellenleiter (15) mit einer Auswerte- und/oder Anzeigeeinrichtung (16) verbunden ist.

6. Schaltungsanordnung nach Anspruch 4, dadurch gekennzeichnet, daß zur Begrenzung der stromproportionalen Spannung eine Zenerdiode (13) parallel zur Leuchtdiode (14) geschaltet ist.

## Claims

1. Circuit arrangement for simulating the electrical behaviour of a spark plug, characterized in that the spark plug simulator is a series circuit comprising at least one resistor (8) and two break-over diodes (6, 7) connected antiparallel.

2. Circuit arrangement according to Claim 1, characterized in that the break-over diodes (6, 7) become conductive at a preselectable breakdown voltage corresponding to the response voltage of an ignition coil, the drop in voltage at the resistor (8) then corresponding to the sparking voltage of a spark plug.

3. Circuit arrangement according to one of the preceding claims, characterized in that the original spark-plug sockets of an ignition system can be plugged directly onto the spark plug simulator by virtue of appropriate design of a clamp (5).

4. Circuit arrangement according to one of the preceding claims, characterized in that a bridge rectifier (10) which rectifies the dropping, current-proportional voltage for a subsequent evaluation is connected parallel to the resistor (9).

5. Circuit arrangement according to Claim 4, characterized in that an LED (14) is connected downstream of the bridge rectifier, the said LED (14) being connected by optical waveguide (15) to an evaluation and/or display device (16).

6. Circuit arrangement according to Claim 4, characterized in that in order to limit the current-proportional voltage a Zener diode (13) is connected parallel to the LED (14).

## Revendications

1. Dispositif de circuit pour la simulation du comportement électrique d'une bougie d'allumage, caractérisé en ce que la simulation des bougies est un montage en série d'au moins une résistance (8) et de deux diodes basculantes antiparallèles (6, 7).

2. Dispositif de circuit selon la revendication 1, caractérisé en ce que les diodes basculantes (6, 7) deviennent conductrices, lors d'une tension de rupture présélectionnable, correspondant à la tension de réponse d'une bobine d'allumage.

3. Dispositif de circuit selon une des revendications précédentes, caractérisé en ce que les cosses de bougie d'origine d'une installation d'allumage par suite de la réalisation correspondante d'une borne (5) peuvent être fixées directement sur la simulation de bougies.

4. Dispositif de circuit selon une des revendications précédentes, caractérisé en ce qu'on a monté en parallèle à la résistance (9) un redresseur en pont (12), qui redresse pour une évaluation consécutive, la tension proportionnelle au courant, en chute.

5. Dispositif de circuit selon la revendication 4, caractérisé en ce qu'une diode lumineuse (14) est branchée après le redresseur à pont, diode qui est reliée par un guide d'ondes lumineuses (15) à un dispositif d'évaluation et/ou indicateur (16).

6. Dispositif de circuit selon la revendication 4, caractérisé en ce que pour la limitation de la tension proportionnelle au courant une diode Zener (13) est montée en parallèle à la diode lumineuse (14).
